(19) Europäisches Patentamt

European Patent Office

Office européen des brevets

(11) Veröffentlichungsnummer: **0 240 070 B1**

(12) **EUROPÄISCHE PATENTSCHRIFT**

(45) Veröffentlichungstag der Patentschrift: **21.10.92**

(51) Int. Cl.⁵: **H01L 21/263**, H01L 21/24

(21) Anmeldenummer: **87200532.7**

(22) Anmeldetag: **23.03.87**

(54) **Verfahren zum Herstellen von Halbleiter-Bauelementen.**

(30) Priorität: **29.03.86 DE 3610709**

(43) Veröffentlichungstag der Anmeldung:
**07.10.87 Patentblatt 87/41**

(45) Bekanntmachung des Hinweises auf die
Patenterteilung:
**21.10.92 Patentblatt 92/43**

(84) Benannte Vertragsstaaten:
**DE FR GB IT**

(56) Entgegenhaltungen:
EP-A- 0 024 572
DE-A- 3 414 781
US-A- 3 900 944

THIN SOLID FILMS, Band 69, Nr. 1, Juni 1980,
Seiten 379-386, Lausanne, CH; R. J. MILLER
et al.: "Electromigration in gold and copper
thin film conductors"

PATENT ABSTRACTS OF JAPAN, Band 7, Nr.
182 (E-192)(1327), 11. August 1983;& JP-
A-58086724

PATENT ABSTRACTS OF JAPAN, Band 10,
Nr. 65 (E-388)(2122), 14. März 1986;& JP-
A-60214578

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB IT**

(72) Erfinder: **Tommalla, Dieter
Bi de Möhl 186
W-2200 Elmshorn(DE)**
Erfinder: **König, Kurt
Reichenberger Strasse 24
W-2080 Pinneberg(DE)**

(74) Vertreter: **Kupfermann, Fritz-Joachim,
Dipl.-Ing. et al
Philips Patentverwaltung GmbH Wendenstrasse 35 Postfach 10 51 49
W-2000 Hamburg 1(DE)**

**Beschreibung**

Die Erfindung betrifft ein Verfahren zum Herstellen von Halbleiter-Bauelementen, bei dem eine Oberfläche des Halbleiterkörpers und darauf angebrachte Metallisierungsschichten aus Gold mit einer Passivierungsschicht aus Siliziumnitrid bedeckt werden.

Das Bedecken der Oberfläche von Halbleiterkörpern mit einer durch PCVD (plasma activated chemical vapor deposition) niedergeschlagenen Schicht ist z. B. aus "Solid State Technology", April 1981, 167 bis 171 bekannt. Befinden sich auf der mit der Passivierungsschicht bedeckten Oberfläche des Halbleiterkörpers Metallisierungsschichten, so werden diese zunächst von der Passivierungsschicht mit bedeckt, die dann an den Stellen, an denen die Metallisierungsschicht kontaktiert werden sollen entfernt werden. Bestehen diese Metallisierungsschichten aus Gold, so zeigt sich, daß die Haftung der Passivierungsschicht aus Siliziumnitrid auf ihnen nicht sehr gut ist und die Gefahr besteht, daß die Passivierungsschicht beim Freilegen der Metallisierungsschichten, z. B. durch Ätzen, teilweise abblättert.

Bei einem Verfahren der eingangs genannten Art ist daher die Ausbeute erheblich herabgesetzt. Aus EP-A-0 024 572 und Thin Solid Films 69 (1980), p. 379-386 ist das Aufbringen auf eine Goldschicht einer Schicht aus Ta, Ti/W oder Mo bekannt, um die Haftung einer darauf aufgebrachten Passivierungsschicht zu erhöhen. Der Erfindung liegt die wesentliche Aufgabe zugrunde eine Legierungsbildung zwischen dem Gold der Metallisierungsschicht und dem Metall der Haftschicht zu vermeiden.

Diese Aufgabe wird erfindungsgemäß dadurch gelöst, daß die Haftschicht aus einem oder mehreren der Metalle W, Ti und Mo besteht, und in einer $N_2$-haltigen Atmosphäre aufgesputtert wird.

Eine solche Haftschicht zwischen den Metallisierungsschichten aus Gold und der Passivierungsschicht aus Siliziumnitrid führt zu einer sehr guten Haftung, so daß beim Ätzen der Passivierungsschicht kein Ablösen mehr zu befürchten ist.

Weitere Ausgestaltung der Erfindung ergeben sich aus den Unteransprüchen.

Für ein Ausführungsbeispiel der Erfindung wird im folgenden anhand der beigefügten Zeichnung mehr erläutert.

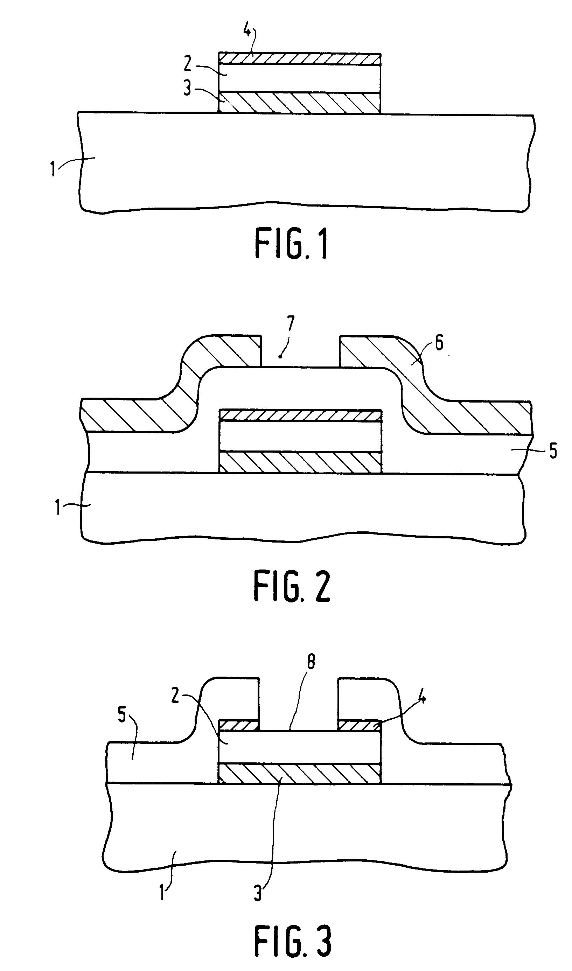

Die Fig. 1 bis 3
zeigen jeweils einen Ausschnitt aus einem Halbleiter-Bauelement das mit dem Verfahren nach der Erfindung hergestellt wird, in aufeinander folgenden Stufen seiner Herstellung.
Figur 1 zeigt einen Halbleiterkörper 1 aus z. B. Silizium auf dessen einer Oberfläche eine Metallisierungsschicht 2 aus Gold angebracht ist. Die Dicke dieser Metallisierungsschicht beträgt etwa 0,6 $\mu$m.
Sie liegt nicht unmittelbar auf der Oberfläche sondern auf einer die Haftung verbessernden Schicht 3, die aus WTi (90 %W 10 %Ti) besteht und eine Dicke von 0,4 $\mu$m hat. Die Oberfläche der Metallisierungsschicht 2 ist mit einer Haftschicht 4 bedeckt, die in den hier beschriebenen Ausführungsbeispiel aus WTi (90%W, 10 %Ti) besteht und deren Dicke etwa 50 nm beträgt.

Die Haftschicht 4 wird auf die Metallisierungsschicht 2 aufgesputtert und zwar in einer $N_2$-haltigen Atmophäre um so eine Legierungsbildung zwischen dem Gold der Metallisierungsschicht und dem WTi der Haftschicht zu vermeiden. Der beim Aufsputtern üblicherweise verwendeten Inertatmosphäre aus Argon ist etwa 30 Vol.% $N_2$ beigefügt.

Die Oberfläche des Halbleiterkörpers 1 mit der darauf liegenden Metallisierungsschicht 2 die von der Haftschicht 4 bedeckt ist wird nun - wie es die Figur 2 zeigt - mit einer Passivierungsschicht 5 aus Siliziumnitrid bedeckt. Diese Passivierungsschicht 5 wird durch PCVD (plasma activated chemical vapor deposition) niedergeschlagen wie dies z.B. in der oben bereits genannten Literaturstelle "Solid State Technology", April 1981, 167 bis 171 beschrieben ist.

Die Dicke der Nitridschicht beträgt etwa 1 $\mu$m.

Anschließend wird die Passivierungsschicht 5 auf übliche Art und Weise mit einer Fotolackmaske 6 bedeckt, die wie in Figur 2 dargestellt eine Öffnung 7 enthält durch die hindurch durch ein geeignetes Ätzverfahren (z.B. chemisches Ätzen oder Sputterätzen) die Passivierungsschicht 5 und die Haftschicht 4 über einer freizulegenden Fläche 8 der Metallisierungsschicht 2 entfernt werden. An dieser Fläche 8 kann dann die Metallisierungsschicht 2 auf geeignete Weise kontaktiert werden.

Das Entfernen der beiden genannten Schichten geschieht vorzugsweise durch reaktives Sputterätzen. Das vollständige Entfernen beider Schichten kann leicht optisch kontrolliert werden, da nach dem vollständigen Entfernen der Haftschicht 4 eine deutliche Farbänderung von der grauen Haftschicht zu dem gelbglänzenden Gold der Metallisierungsschicht auftritt.

**Patentansprüche**

1. Verfahren zum Herstellen von Halbleiter-Bauelementen, bei dem eine Oberfläche des Halbleiterkörpers und darauf angebrachten Metallisierungsschichten aus Gold mit einer Passivierungsschicht aus Siliziumnitrid bedeckt werden, und vor dem Aufbringen der Nitridschicht, auf die Metallisierungsschichten eine metallische Haftschicht aufgebracht wird, dadurch gekennzeichnet, daß die Haftschicht aus einem oder mehreren der Metalle W, Ti und Mo besteht, und in einer $N_2$-haltigen Atmosphäre aufgesputtert wird.

2. Verfahren nach Anspruch 1,
dadurch gekennzeichnet, daß die Passivierungsschicht durch PCVD (plasma activated chemical vapor deposition) niedergeschlagen wird.

3. Verfahren nach Anspruch 1,
dadurch gekennzeichnet, daß die Haftschicht mit einer Dicke kleiner als 100 nm aufgebracht wird.

4. Verfahren nach Anspruch 3,
dadurch gekennzeichnet, daß die Haftschicht mit einer Dicke von etwa 50 nm aufgebracht wird.

5. Verfahren nach Anspruch 1,
dadurch gekennzeichnet, daß die Haftschicht aus 10 Gew.% Ti und 90 Gew.% W besteht.

6. Verfahren nach Anspruch 1,
dadurch gekennzeichnet, daß die Haftschicht aus Ti besteht.

7. Verfahren nach Anspruch 1,
dadurch gekennzeichnet, daß die Haftschicht in einer 30Vol.% $N_2$ enthaltenden Atmosphäre aufgesputtert wird.

## Claims

1. A method of manufacturing semiconductor elements whereby a surface of the semiconductor body and metallization layers of gold provided thereon are coated with a passivating layer of silicon nitride, and a metal adhesion layer is provided on the metallization layers before the nitride layer is provided, characterized in that the adhesion layer consists of one or several of the metals W, Ti and Mo and is applied in an $N_2$-containing atmosphere by sputtering.

2. A method as claimed in Claim 1, characterized in that the passivating layer is deposited by PCVD (Plasma-activated Chemical Vapour Depositon).

3. A method as claimed in Claim 1, characterized in that the adhesion layer is applied to a thickness of less than 100 nm.

4. A method as claimed in Claim 3, characterized in that the adhesion layer is applied to a thickness of approximately 50 nm.

5. A method as claimed in Claim 1, characterized in that the adhesion layer consists of 10% by weight Ti and 90% by weight W.

6. A method as claimed in Claim 1, characterized in that the adhesion layer consists of Ti.

7. A method as claimed in Claim 1, characterized in that the adhesion layer is applied by sputtering in an atmosphere containing 30% by volume of $N_2$.

## Revendications

1. Procédé de fabrication de dispositifs semiconducteurs consistant à recouvrir une surface du corps semiconducteur et des couches de métallisation d'or superposées à celle-ci d'une couche de passivation de nitrure de silicium et à former sur les couches de métallisation, avant le dépôt de la couche de nitrure, une couche métallique d'adhérence, caractérisé en ce que la couche d'adhérence est constituée par un ou plusieurs des métaux W, Ti et Mo et en ce qu'elle est formée par pulvérisation dans une atmosphère contenant du $N_2$.

2. Procédé selon la revendication 1, caractérisé en ce que la couche de passivation est formée par la méthode PCVD (plasma activated chemical vapor deposition : dépôt chimique en phase vapeur activé par plasma).

3. Procédé selon la revendication 1, caractérisé en ce que la couche d'adhérence est formée jusqu'à une épaisseur inférieure à 100 nm.

4. Procédé selon la revendication 3, caractérisé en ce que la couche d'adhérence est formée jusqu'à une épaisseur de 50 nm environ.

5. Procédé selon la revendication 1, caractérisé en ce que la couche d'adhérence est constituée de 10% en poids de Ti et de 90% en poids de W.

6. Procédé selon la revendication 1, caractérisé en ce que la couche d'adhérence est en Ti.

7. Procédé selon la revendication 1, caractérisé en ce que la couche d'adhérence est formée par pulvérisation dans une atmosphère contenant 30% en volume de $N_2$.

FIG. 1

FIG. 2

FIG. 3